# EUROPÄISCHE PATENTSCHRIFT

(11) **EP 4 182 705 B1**
(45) Veröffentlichungstag und Bekanntmachung des Hinweises auf die Patenterteilung: **19.02.2025**
(21) Anmeldenummer: 21721035.0
(22) Anmeldetag: 20.04.2021
(51) Int. Cl.: G01R 1/20, G01R 15/20

(54) **STROMMESSVORRICHTUNG MIT REDUNDANTER STROMMESSUNG**
CURRENT MEASURING APPARATUS WITH REDUNDANT CURRENT MEASUREMENT
APPAREIL DE MESURE DE COURANT À MESURE REDONDANTE DE COURANT

(30) Priorität: 15.07.2020 DE 102020118637
(43) Veröffentlichungstag der Anmeldung: 24.05.2023
(73) Patentinhaber: Isabellenhütte Heusler GmbH & Co. KG, 35683 Dillenburg (DE)
(72) Erfinder: MARIEN, Jan, 35745 Herborn (DE); KRAMM, Benedikt, 35435 Wettenberg (DE)
(74) Vertreter: v. Bezold & Partner Patentanwälte - PartG mbB
(86) Internationale Anmeldenummer: PCT/EP2021/060245
(87) Internationale Veröffentlichungsnummer: WO 2022/012791

(56) Entgegenhaltungen:
- DE-A1- 102012 212 367
- US-A- 5 841 272
- US-A1- 2011 221 429
- US-A1- 2015 088 438
- US-A1- 2015 309 080

## Beschreibung

Die Erfindung betrifft eine Strommessvorrichtung zur redundanten Messung eines elektrischen Stroms.

Aus EP 0 605 800 A1 ist eine Strommessvorrichtung bekannt, die einen niederohmigen Strommesswiderstand ("Shunt") aufweist, wobei der zu messende elektrische Strom gemäß der Vierleitertechnik gemessen wird. Hierbei wird der zu messende elektrische Strom durch den niederohmigen Strommesswiderstand geleitet, wobei der Spannungsabfall über dem niederohmigen Strommesswiderstand gemessen wird. Der Spannungsabfall über dem niederohmigen Strommesswiderstand bildet hierbei gemäß dem ohmschen Gesetz ein Maß für den zu messenden elektrischen Strom.

Weiterhin ist es aus dem Stand der Technik bekannt, zur Strommessung Hall-Sensoren einzusetzen, die das von dem zu messenden elektrischen Strom erzeugte Magnetfeld erfassen.

Darüber hinaus ist aus EP 2 511 714 A2 eine Strommessvorrichtung bekannt, die beide Messprinzipien miteinander kombiniert und sowohl einen niederohmigen Strommesswiderstand ("Shunt") als auch einen Hall-Sensor aufweist, was eine redundante Strommessung ermöglicht. Bei dieser bekannten Strommessvorrichtung wird der zu messende elektrische Strom durch den niederohmigen Strommesswiderstand geleitet, wobei der Hall-Sensor oberhalb des niederohmigen Strommesswiderstands angeordnet ist und denselben Strom misst. Diese bekannten Strommessvorrichtungen können Ströme bis ±1000 A messen, mit einer Auflösung von 1 bis 5 A und einer Toleranz von ±10%.

Weiterhin sind Hall-Sensoren mit einem integrierten Leiter bekannt, wobei der zu messende Strom durch den integrierten Leiter fließt. Derartige Hall-Sensoren haben eine Auflösung von ca. 0,5 bis 1 A mit einer Toleranz von ±1%.

Nachteilig an diesen bekannten Strommessvorrichtungen ist jedoch die Tatsache, dass der Messbereich der gesamten Strommessvorrichtung bis ±1000 A limitiert ist und eine niedrige Auflösung und hohe Toleranz aufweist. Die Chip-Sensoren haben einen deutlich niedrigeren Messbereich, aber dafür eine bessere Auflösung und kleinere Toleranz.

Ferner sind aus DE 10 2011 088 893 A1 und US 2020/0300917 A1 Strommessvorrichtungen gemäß dem Oberbegriff von Anspruch 1 bekannt. Diese bekannten Strommessvorrichtungen sind jedoch noch nicht optimal.

Weiterhin ist zum allgemeinen technischen Hintergrund der Erfindung hinzuweisen auf US 5,841,272, US 2011/0221429 A1, US 2015/088438 A1 und US 2015/309080 A1.

Schließlich offenbart DE 10 2012 212 367 A1 eine Strommessvorrichtung gemäß dem Oberbegriff von Anspruch 1. Dies bekannte Strommessvorrichtung ist jedoch nicht vollständig befriedigend.

Der Erfindung liegt deshalb die Aufgabe zugrunde, eine entsprechend verbesserte Strommessvorrichtung zu schaffen.

Diese Aufgabe wird durch eine erfindungsgemäße Strommessvorrichtung gemäß dem Hauptanspruch gelöst.

Die erfindungsgemäße Strommessvorrichtung weist zunächst in Übereinstimmung mit dem Stand der Technik einen niederohmigen Strommesswiderstand auf, um eine Strommessung gemäß der Vierleitertechnik zu ermöglichen, wie sie beispielsweise aus EP 0 605 800 A1 bekannt ist. Dabei wird der elektrische Strom durch den niederohmigen Strommesswiderstand geleitet, wobei der Spannungsabfall über dem niederohmigen Strommesswiderstand gemessen wird. Der Spannungsmesswert bildet dann entsprechend dem ohmschen Gesetz ein Maß für den elektrischen Strom.

Weiterhin umfasst die erfindungsgemäße Strommessvorrichtung in Übereinstimmung mit dem Stand der Technik gemäß EP 2 511 714 A2 auch einen Magnetfeldsensor zur redundanten Strommessung, d.h. der Magnetfeldsensor misst den elektrischen Strom gemäß einem anderen Messprinzip als der Vierleitertechnik. Beispielsweise kann es sich bei dem Magnetfeldsensor um einen Hall-Sensor handeln, wie er an sich bekannt ist. Es ist jedoch alternativ auch möglich, dass es sich bei dem Magnetfeldsensor um einen magnetoresistiven Magnetfeldsensor handelt, wie beispielsweise einen sogenannten GMR-Sensor (GMR: Giant magnetoresistance), wie er an sich ebenfalls aus dem Stand der Technik bekannt ist. Die Erfindung ist also nicht auf einen bestimmten Typ eines Magnetfeldsensors beschränkt.

Die erfindungsgemäße Strommessvorrichtung zeichnet sich nun gegenüber dem Stand der Technik dadurch aus, dass der zu messende elektrische Strom in der Messvorrichtung aufgeteilt wird in einen Hauptstrompfad mit einem Hauptstrom und einen Nebenstrompfad mit einem Nebenstrom, wobei der Hauptstrompfad und der Nebenstrompfad zusammen eine Parallelschaltung bilden.

Der niederohmige Strommesswiderstand ist hierbei in dem Hauptstrompfad angeordnet und wird von dem Hauptstrom durchflossen, so dass der Hauptstrom gemäß der Vierleitertechnik gemessen werden kann.

Der Magnetfeldsensor ist dagegen in dem Nebenstrompfad angeordnet und misst den Nebenstrom nach einem anderen Messprinzip, was wieder eine redundante Strommessung ermöglicht.

Im Gegensatz zu der bekannten Strommessvorrichtung gemäß EP 2 511 714 A2 messen der niederohmige Strommesswiderstand einerseits und der Magnetfeldsensor andererseits also nicht denselben Strom, sondern unterschiedliche Ströme, nämlich den Hauptstrom einerseits und den Nebenstrom andererseits. Dies hat den Vorteil, dass der Messbereich der gesamten Strommessvorrichtung durch den begrenzten Messbereich des Magnetfeldsensors nicht eingeschränkt wird, da der Magnetfeldsensor einen anderen Strom misst als der niederohmige Strommesswiderstand.

Gemäß der Erfindung ist die Parallelschaltung aus dem Hauptstrompfad einerseits und dem Nebenstrompfad andererseits so ausgelegt, dass der Hauptstrom durch den Hauptstrompfad wesentlich größer ist als der Nebenstrom in dem Nebenstrompfad, nämlich um einen Faktor von mindestens 10, 100, 200, 500 oder sogar 1000 größer sein als der Nebenstrom.

Der Nebenstrompfad weist deshalb vorzugsweise einen elektrischen Widerstandswert auf, der wesentlich größer ist als der Widerstandswert des Hauptstrompfads. Beispielsweise kann der Widerstandswert des Nebenstrompfads um einen Faktor von 10, 100, 200, 500 oder 1000 größer sein als der Widerstandswert des Hauptstrompfads.

In absoluten Zahlen betrachtet kann der Widerstandswert des Hauptstrompfads im Bereich von 1 µΩ, 10 µΩ, 20 µΩ, 50 µΩ, 100 µΩ, 200 µΩ oder 500 µΩ liegen, wobei in dieser Bereichsdefinition Abweichungen von maximal ±50 %, ±20 %, ±10 %, ±5 %, ±2 % oder ±1% möglich sind.

Der Widerstandswert des Nebenstrompfads liegt dagegen in absoluten Zahlen betrachtet beispielsweise im Bereich von 1 mΩ, 2 mΩ, 5 mΩ, 10 mΩ, 20 mΩ, 50 mΩ oder 100 mΩ, wobei in dieser Bereichsdefinition Abweichungen von maximal plus ±50 %, ±20 %, ±10 %, ±5 %, ±2 % oder ±1% möglich sind.

Der niederohmige Strommesswiderstand weist vorzugsweise einen größeren Strommessbereich auf als der Magnetfeldsensor. Der Strommessbereich des Magnetfeldsensors ist also in der Regel wesentlich kleiner als der Strommessbereich des niederohmigen Strommesswiderstands. Dies ist jedoch bei der erfindungsgemäßen Strommessvorrichtung nicht störend, weil der Magnetfeldsensor einerseits und der niederohmige Strommesswiderstand andererseits unterschiedliche Ströme messen, so dass der kleinere Strommessbereich des Magnetfeldsensors den gesamten Strommessbereich der erfindungsgemäßen Strommessvorrichtung nicht einschränkt.

Weiterhin kann in dem Nebenstrompfad mit dem Magnetfeldsensor zusätzlich ein Ausgleichswiderstand angeordnet sein, um die Temperaturabhängigkeit der Messung zu verringern. Die Idee der Verwendung eines Ausgleichswiderstands zur Verringerung der Temperaturabhängigkeit der Messung ist grundsätzlich aus DE 10 2016 014 130 B3 bekannt, so dass auf eine detaillierte Beschreibung der Funktionsweise des Ausgleichswiderstands verzichtet werden kann. An dieser Stelle ist lediglich zu erwähnen, dass der Hauptstrompfad und der Nebenstrompfad bei der erfindungsgemäßen Strommessvorrichtung jeweils Leitermaterial (z.B. Kupfer) mit einem bestimmten ersten Temperaturkoeffizienten bezüglich des Widerstandswerts und Widerstandsmaterial mit einem bestimmten zweiten Temperaturkoeffizienten bezüglich des Widerstandswerts enthalten, wobei der erste Temperaturkoeffizient des Leitermaterials wesentlich größer ist als der zweite Temperaturkoeffizient des Widerstandsmaterials. Der Widerstandswert des Leitermaterials ist also wesentlich temperaturabhängiger als der Widerstandswert des Widerstandsmaterials. Beispielsweise können sich die beiden Temperaturkoeffizienten des Leitermaterials einerseits und des Widerstandsmaterials andererseits um einen Faktor von mindestens 10, 20, 50, 100 oder 200 unterscheiden. Der Ausgleichswiderstand in dem Nebenstrompfad besteht dagegen aus einem Widerstandsmaterial, das einen wesentlich geringeren Temperaturkoeffizienten aufweist als das Leitermaterial. Der Ausgleichswiderstand ist nun hinsichtlich seines Widerstandswerts so bemessen, dass die Temperaturabhängigkeit des Widerstandswerts des Leitermaterials mindestens teilweise kompensiert wird. So kann der erste Temperaturkoeffizient des Leitermaterials im Bereich von 1.000-10.000 ppm/K oder 3.600-4.000 ppm/K liegen, während der zweite Temperaturkoeffizient des Widerstandsmaterials im Bereich von 0 bis ±100 ppm/K, 0 bis ±50 ppm/K, 0 bis ±20 ppm/K oder 0 bis ±10 ppm/K liegt.

Zur Kompensation der Temperaturabhängigkeiten weisen der Hauptstrompfad und der Nebenstrompfad vorzugsweise das gleiche Widerstandsverhältnis auf zwischen dem Widerstandswert des Leitermaterials und dem Widerstandswert des Widerstandsmaterials des niederohmigen Strommesswiderstands bzw. des Ausgleichswiderstands. Vorzugsweise ist die Abweichung des Widerstandsverhältnisses zwischen dem Hauptstrompfad und dem Nebenstrompfad kleiner als ±20%, ±10%, ±5% oder ±2%.

Der niederohmige Strommesswiderstand kann bei der erfindungsgemäßen Strommessvorrichtung in herkömmlicher Weise ausgebildet sein. Vorzugsweise ist der niederohmige Strommesswiderstand plattenförmig mit plattenförmigen Stromanschlussteilen und einem plattenförmigen Widerstandselement, wobei das plattenförmige Widerstandselement in Stromflussrichtung zwischen den beiden plattenförmigen Stromanschlussteilen angeordnet ist, wie es an sich bereits aus EP 0 605 800 A1 bekannt ist.

Weiterhin besteht im Rahmen der Erfindung die Möglichkeit, dass mindestens eines der beiden plattenförmigen Stromanschlussteile und/oder das Widerstandselement des niederohmigen Strommesswiderstands seitlich einseitig oder beidseitig einen Einschnitt zum Trimmen des Widerstandswerts aufweist. Darüber hinaus können die plattenförmigen Anschlussteile auch mittig einen Einschnitt zum Trimmen des Widerstandswerts aufweisen.

Es wurde vorstehend bereits erwähnt, dass bei der Strommessung gemäß der Vierleitertechnik der Spannungsabfall über dem niederohmigen Strommesswiderstand gemäß dem Ohmschen Gesetz ein Maß für den elektrischen Strom ist, der durch den niederohmigen Strommesswiderstand fließt. Die erfindungsgemäße Strommessvorrichtung weist deshalb mindestens ein Paar von Spannungsmesskontakten auf, die den Spannungsabfall über dem niederohmigen Strommesswiderstand messen.

Vorzugsweise sind sogar mehrere Paare von Spannungsmesskontakten vorgesehen, die quer zur Stromflussrichtung verteilt angeordnet sind, um Inhomogenitäten der Stromdichte in dem Strommesswiderstand messtechnisch kompensieren zu können. Die Idee zur Messung des Spannungsabfalls über dem niederohmigen Strommesswiderstand mittels mehrerer Paare von Spannungsmesskontakten ist an sich aus WO 2014/161624 A1 bekannt und muss deshalb nicht im Detail beschrieben werden.

Weiterhin im Rahmen der Erfindung besteht auch die Möglichkeit, dass an dem niederohmigen Strommesswiderstand mehrere Paare von Spannungsmesskontakten in Stromflussrichtung hintereinander angeordnet sind, wie es in DE 10 2020 111 634.9 beschrieben ist.

Darüber hinaus können in den Stromanschlussteilen des niederohmigen Strommesswiderstands mittig Einschnitte angeordnet sein, die auch als Stromschatten bezeichnet werden und jeweils einen der Spannungsmesskontakte umgeben, um die Stromdichte in den Stromanschlussteilen zu beeinflussen. Derartige Stromschatten sind an sich bereits aus dem Stand der Technik bekannt und beispielsweise in DE 10 2020 111 634.9 beschrieben.

Bei dem bevorzugten Ausführungsbeispiel der Erfindung ist auf dem plattenförmigen Strommesswiderstand eine Leiterplatte angeordnet, die auch den Magnetfeldsensor (z.B. Hall-Sensor, GMR-Sensor) trägt. Der Magnetfeldsensor einerseits und der Strommesswiderstand andererseits befinden sich hierbei vorzugsweise auf gegenüberliegenden Seiten der Leiterplatte.

Die Leiterplatte ist hierbei vorzugsweise fest mit dem niederohmigen Strommesswiderstand verbunden und weist Durchkontaktierungen auf, um die beiden Stromanschlussteile des niederohmigen Strommesswiderstands kontaktieren zu können. Die Durchkontaktierungen kontaktieren vorzugsweise die Stromanschlussteile stromabwärts vor dem Widerstandselement des niederohmigen Strommesswiderstands und stromabwärts hinter dem Widerstandselement des niederohmigen Strommesswiderstands.

Der Nebenstrompfad verläuft hierbei vorzugsweise auf oder in der Leiterplatte, während der Hauptstrompfad durch den niederohmigen Strommesswiderstand verläuft.

Die Leiterplatte kann auch eine Auswertungsschaltung tragen, die den Spannungsabfall über dem Widerstandselement des niederohmigen Strommesswiderstands, das Ausgangssignal des Magnetfeldsensors und/oder den Spannungsabfall über dem Ausgleichswiderstand in dem Nebenstrompfad misst.

Weiterhin kann die Leiterplatte eine Schnittstelle aufweisen, um das Ausgangssignal des Magnetfeldsensors und/oder den Spannungsmesswert der Spannung über dem Widerstandselement des niederohmigen Strommesswiderstands auszugeben.

In dem bevorzugten Ausführungsbeispiel der Erfindung weist die Leiterplatte mehrere parallele Lagen auf. Der Ausgleichswiderstand ist hierbei vorzugsweise auf der obersten Lage der Leiterplatte angeordnet. Der Nebenstrompfad mit dem Nebenstrom ist vorzugsweise stromaufwärts vor dem Ausgleichswiderstand zunächst auf mehrere Lagen der Leiterplatte aufgeteilt und wird erst kurz vor dem Ausgleichswiderstand zusammengeführt, so dass der gesamte Nebenstrom durch den Ausgleichswiderstand fließt. Stromabwärts hinter dem Ausgleichswiderstand wird der Nebenstrompfad dann wieder auf die verschiedenen Lagen der Leiterplatte aufgeteilt. Diese Aufteilung des Nebenstrompfads auf mehrere Lagen der Leiterplatte bietet den Vorteil, dass der Widerstandswert in dem Nebenstrompfad relativ klein ist.

Weiterhin ist zu erwähnen, dass die Strommessvorrichtung üblicherweise einen Hochspannungsbereich und einen Niederspannungsbereich aufweist. Der niederohmige Strommesswiderstand liegt hierbei vollständig in dem Hochspannungsbereich, während der Magnetfeldsensor den Hochspannungsbereich von dem Niederspannungsbereich trennt. So weist der Magnetfeldsensor eine Niederspannungsseite auf, die beispielsweise dazu dient, Ausgangssignale auszugeben und eine Versorgungsspannung zuzuführen. Darüber hinaus weist der Magnetfeldsensor eine Hochspannungsseite auf, die den Nebenstrompfad einschließt. In dem Magnetfeldsensor befindet sich hierbei eine Isolation, die den Hochspannungsbereich von dem Niederspannungsbereich trennt.

Allgemein ist zu erwähnen, dass die erfindungsgemäße Strommessvorrichtung einen Strommessbereich aufweisen kann, der bis mindestens 0,5 kA, 1 kA, 2 kA, 5 kA, 10 kA oder 20 kA reicht.

Weiterhin ist zu erwähnen, dass die erfindungsgemäße Strommessvorrichtung eingangsseitig vorzugsweise eine hohe Spannungsfestigkeit aufweist, die beispielsweise bis zu einer Betriebsspannung von mindestens 100 V, 500 V oder 1 kV reichen kann.

Bei dem vorstehend erwähnten Leitermaterial der Stromanschlussteile handelt es sich vorzugsweise um Kupfer oder eine Kupferlegierung oder um Aluminium oder eine Aluminiumlegierung.

Das Widerstandsmaterial des Widerstandselements des niederohmigen Strommesswiderstands kann beispielsweise eine Kupferlegierung sein, insbesondere eine Kupfer-Mangan-Nickellegierung. Beispielsweise kann es sich hierbei um CuMn12Ni2, Cu84Ni4Mn12 oder Cu65Mn25Ni10 handeln. Alternativ besteht die Möglichkeit, dass das Widerstandsmaterial eine Kupfer-Mangan-Zinn-Legierung ist, wie beispielsweise CuMn7Sn2,3. Ferner besteht auch die Möglichkeit, dass es sich bei dem Widerstandsmaterial um eine Kupfer-Chrom-Legierung handelt. Schließlich kann das Widerstandsmaterial auch eine Nickellegierung sein, wie beispielsweise NiCr oder CuNi.

Ferner ist zu erwähnen, dass das Leitermaterial der Stromanschlussteile des niederohmigen Strommesswiderstands vorzugsweise einen geringeren spezifischen elektrischen Widerstand hat als das Widerstandsmaterial des Widerstandselements.

Das Leitermaterial der Stromanschlussteile des niederohmigen Strommesswiderstands kann beispielsweise einen spezifischen elektrischen Widerstand von weniger als 20 µΩcm, 10 µΩcm, 5 µΩcm oder 2 µΩcm haben.

Das Widerstandsmaterial des Widerstandselements des niederohmigen Strommesswiderstands hat dagegen vorzugsweise einen spezifischen elektrischen Widerstand von weniger als 1000 µΩcm, 500 µΩcm, 250 µΩcm, 100 µΩcm oder 50 µΩcm.

Allgemein ist noch zu erwähnen, dass der niederohmige Strommesswiderstand vorzugsweise einen Widerstandswert hat, der höchstens 500 mΩ, 200 mΩ, 100 mΩ, 50 mΩ, 20 mΩ, 10 mΩ, 5 mΩ, 2 mΩ oder 1 mΩ beträgt.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert.
Figur 1 zeigt eine Perspektivansicht einer erfindungsgemäßen Strommessvorrichtung mit einem niederohmigen Strommesswiderstand und einem Hall-Sensor.
Figur 2 zeigt eine Aufsicht auf die Strommessvorrichtung gemäß Figur 1.
Figur 3 zeigt eine Aufsicht auf den Strommesswiderstand gemäß den Figuren 1 und 2.
Figur 4 zeigt ein Ersatzschaltbild der Strommessvorrichtung gemäß den Figuren 1-3.
Figur 5 zeigt eine Abwandlung von Figur 3.
Figur 6 zeigt eine weitere Abwandlung von Figur 3.
Figur 7 zeigt die Temperaturabhängigkeit der Strommessung im Hauptstrompfad mit und ohne Ausgleichswiderstand.
Figur 8 zeigt die Temperaturabhängigkeit der Strommessung im Nebenstrompfad mit und ohne Ausgleichswiderstand.

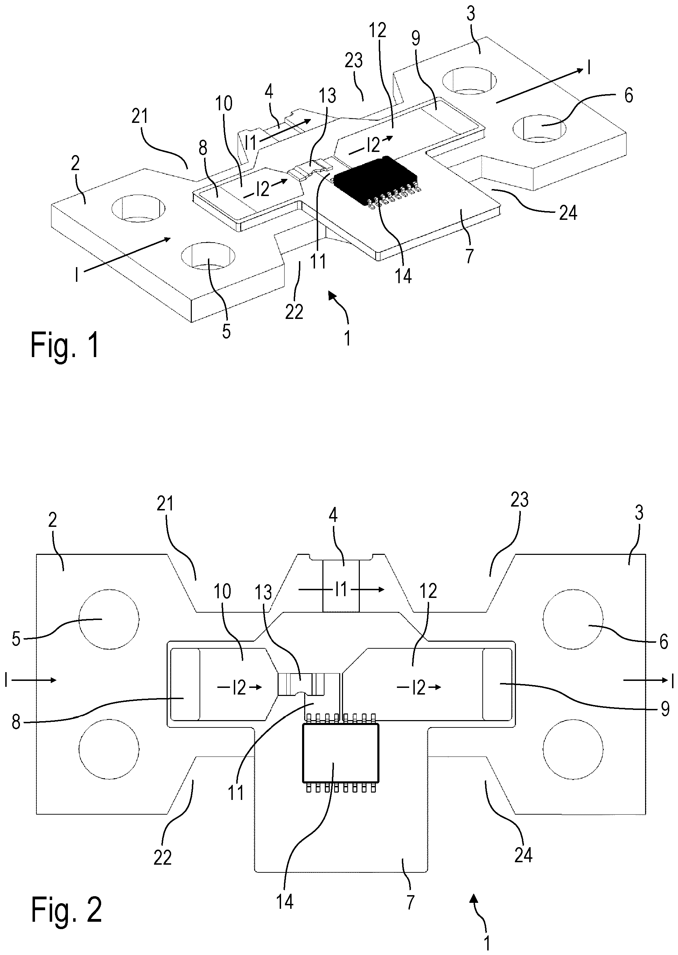

Die Figuren 1-4 zeigen verschiedene Darstellungen einer erfindungsgemäßen Strommessvorrichtung zur Messung eines elektrischen Stroms I, wobei die Strommessung redundant erfolgt, nämlich zum einen gemäß der bekannten Vierleitertechnik und zum anderen durch eine Magnetfeldmessung.

Zur Strommessung gemäß der Vierleitertechnik weist die Strommessvorrichtung einen niederohmigen Strommesswiderstand 1 auf, der aus zwei plattenförmigen Stromanschlussteilen 2, 3 und einem niederohmigen Widerstandselement 4 besteht, das ebenfalls plattenförmig ist und sich in Stromflussrichtung zwischen den beiden Stromanschlussteilen 2, 3 befindet. Das Stromanschlussteil 2 dient hierbei zum Einleiten des zu messenden elektrischen Stroms I in den Strommesswiderstand 1, während das Stromanschlussteil 3 dazu dient, den zu messenden elektrischen Strom I wieder von dem Strommesswiderstand 1 abzuführen, wie es an sich aus dem Stand der Technik bekannt ist.

In den beiden Stromanschlussteilen 2, 3 befinden sich jeweils zylindrische Bohrungen 5, 6, die beispielsweise einen mechanischen Anschluss von Stromschienen ermöglichen.

An der Oberseite des Strommesswiderstands 1 befindet sich eine mehrlagige Leiterplatte 7, die mittels zweier Durchkontaktierungen 8, 9 mit den Anschlussteilen 2 bzw. 3 verbunden ist. Die Durchkontaktierung 8 kontaktiert hierbei das Stromanschlussteil 2, während die Durchkontaktierung 9 das andere Stromanschlussteil 3 kontaktiert.

An der Oberseite der Leiterplatte 7 befinden sich Leiterbahnen 10, 11, 12 und ein Ausgleichswiderstand 13.

Der zu messende elektrische Strom I teilt sich in der erfindungsgemäßen Strommessvorrichtung auf in einen Hauptstrom I1 und einen Nebenstrom 12. Der Hauptstrom I1 fließt in dem Strommesswiderstand 1 von dem Stromanschlussteil 2 durch das Widerstandselement 4 zu dem Stromanschlussteil 3. Der Nebenstrom I2 fließt dagegen von dem Stromanschlussteil 2 durch die Durchkontaktierung 8 über die Leiterbahn 10, durch den Ausgleichswiderstand 13, durch die Leiterbahn 11, durch einen Hall-Sensor 14, durch die Leiterbahn 12, durch die Durchkontaktierung 9 und wieder in das Stromanschlussteil 3, wo sich der Nebenstrom I2 wieder mit dem Hauptstrom I1 zu dem Strom I vereinigt.

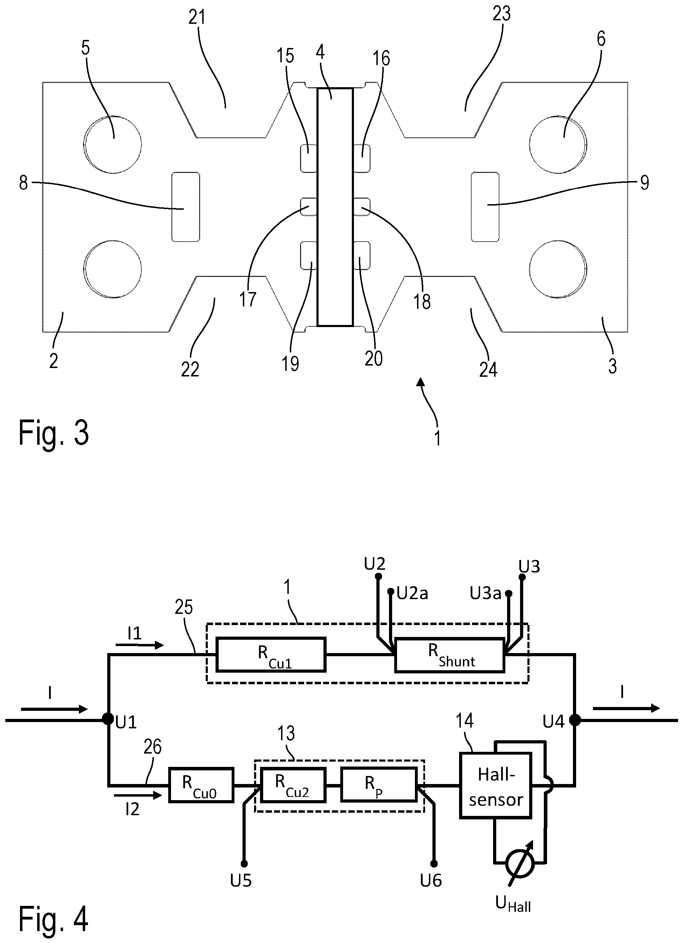

Zur Spannungsmessung gemäß der Vierleitertechnik sind mehrere Paare von Spannungsmesskontakten 15-20 vorgesehen (vgl. Fig. 3), wobei jedes der Paare der Spannungsmesskontakte 15, 16, 17, 18 bzw. 19, 20 die Spannung an dem Stromanschlussteil 2 einerseits und an dem Stromanschlussteil 3 andererseits misst. Die Paare der Spannungsmesskontakte 15-20 sind hierbei quer zur Stromflussrichtung verteilt angeordnet, um Inhomogenitäten der Stromdichte in dem Strommesswiderstand 1 messtechnisch kompensieren zu können, wie in WO 2014/161624 A1 beschrieben ist.

Die Spannungen an den Spannungsmesskontakten 15-20 können beispielsweise von einer Messschaltung gemessen werden, die in den Hall-Sensor 14 integriert sein kann. Es besteht jedoch alternativ auch die Möglichkeit, dass auf der Leiterplatte 7 eine separate Messschaltung angeordnet ist, die den Spannungsabfall über dem Widerstandselement 4 des niederohmigen Strommesswiderstands 1 misst.

Weiterhin ist zu erwähnen, dass der Strommesswiderstand 1 seitlich in den beiden Stromanschlussteilen 2, 3 mehrere Einschnitte 21-24 aufweist, die in Kombination mit dem Ausgleichswiderstand der Temperaturkompensation dienen.

Der Ausgleichswiderstand 13 in dem Nebenstrompfad hat den Zweck, die Temperaturabhängigkeit der Messung zu verringern, wie es an sich bereits aus dem Patent DE 10 2016 014 130 B3 bekannt ist.

Weiterhin ist zu erwähnen, dass der Hall-Sensor 14 den Nebenstrom I2 misst, der hierzu durch den Hall-Sensor 14 fließt. An seiner Messseite ist der Hall-Sensor 14 deshalb der Hochspannung in dem Nebenstrompfad ausgesetzt. Darüber hinaus weist der Hall-Sensor 14 auch eine Niederspannungsseite auf, die dazu dient, ein Messsignal auszugeben und eine Versorgungsspannung zuzuführen. Der Hall-Sensor 14 trennt also die Hochspannungsseite von der Niederspannungsseite und weist hierzu eine integrierte Isolation auf.

Die erfindungsgemäße Strommessvorrichtung ermöglicht eine redundante Strommessung durch unterschiedliche Messprinzipien, nämlich zum einen durch eine Vierleitermessung mittels des niederohmigen Strommesswiderstands 1 und zum anderen durch eine Magnetfeldmessung mittels des Hall-Sensors 14.

Hierbei ist zu erwähnen, dass der Nebenstrom I2 wesentlich kleiner ist als der Hauptstrom I1, der durch den niederohmigen Strommesswiderstand 1 fließt. Der Hall-Sensor 14 kann deshalb einen wesentlich kleineren Strommessbereich aufweisen, was vorteilhaft ist. So haben Hall-Sensoren mit einem integrierten Leiter oftmals einen kleinen Strommessbereich von 5 A bis 50 A.

Im Folgenden wird nun das Ersatzschaltbild gemäß Figur 4 beschrieben, das einen Hauptstrompfad 25 und einen Nebenstrompfad 26 zeigt, wobei der Hauptstrompfad 25 und der Nebenstrompfad 26 eine Parallelschaltung bilden.

In dem Hauptstrompfad 25 ist im Wesentlichen nur der niederohmige Strommesswiderstand 1 angeordnet, der in dem Ersatzschaltbild durch eine Reihenschaltung aus einem ohmschen Widerstand R_{Shunt} und einem ohmschen Widerstand R_{CU1} dargestellt ist. Der Widerstand R_{Shunt} gibt hierbei den ohmschen Widerstand des niederohmigen Widerstandselements 4 wieder. Der ohmsche Widerstand R_{CU1} gibt dagegen den Widerstand der beiden Stromanschlussteile 2, 3 wieder.

In dem Nebenstrompfad 26 ist der Hall-Sensor 14 angeordnet. Weiterhin befindet sich in dem Nebenstrompfad 26 der Ausgleichswiderstand 13, der durch einen ohmschen Widerstand R_{P} und einen ohmschen Widerstand R_{CU2} dargestellt ist. Der Widerstand R_{P} entspricht hierbei dem Widerstandselement des Ausgleichswiderstands 13, während der Widerstand R_{CU2} den beiden Anschlussteilen des Ausgleichswiderstands 13 entspricht. Darüber hinaus ist in dem Nebenstrompfad 16 noch ein Widerstand R_{CU0} dargestellt, der den Widerstandswert der Durchkontaktierungen 8, 9 und der Leiterbahnen 10-12 wiedergibt.

Im Betrieb misst eine Auswertungsschaltung zum einen den Spannungsabfall über dem Widerstandselement 4 des niederohmigen Strommesswiderstands 1. Hierzu sind in dem Ersatzschaltbild gemäß Figur 4 Spannungsmesskontakte U2/U3, U2A/U3A dargestellt, die den Spannungsmesskontakten 15-20 in Figur 3 entsprechen.

Zum anderen erfasst die Auswertungsschaltung die von dem Hall-Sensor 14 gemessene Ausgangsspannung U_{HALL}.

Schließlich erfasst die Auswertungsschaltung auch noch die Spannung, die über dem Ausgleichswiderstand 13 abfällt. Hierzu sind in dem Ersatzschaltbild gemäß Figur 4 die Spannungsmesskontakte U5/U6 dargestellt.

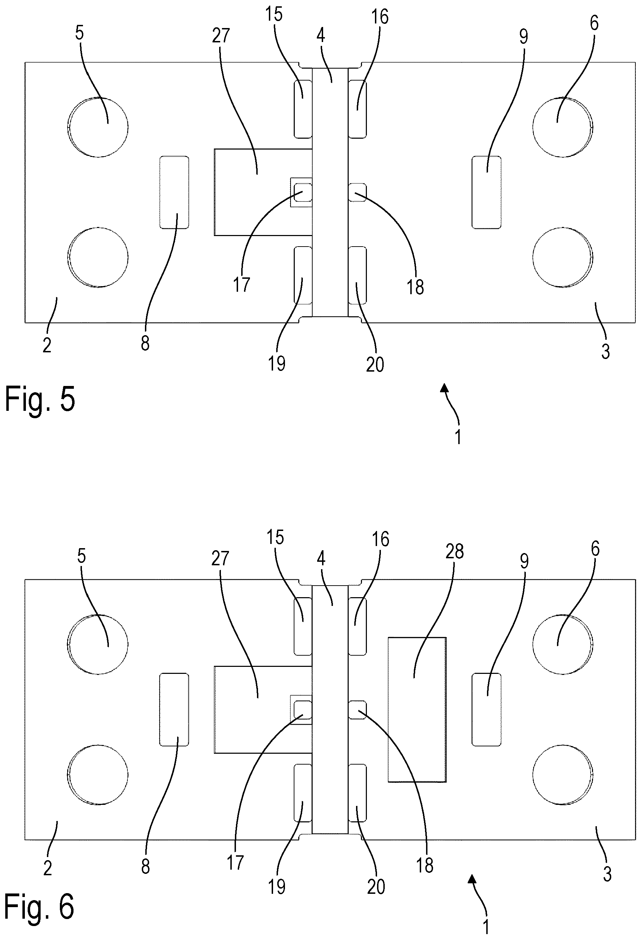

Figur 5 zeigt eine Abwandlung des Strommesswiderstands 1 gemäß Figur 3. Die Abwandlung gemäß Figur 5 stimmt weitgehend mit dem Strommesswiderstand 1 gemäß Figur 3 überein, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass in dem Stromanschlussteil 2 ein Einschnitt 27 angeordnet ist, der auch als Stromschatten bezeichnet wird und den Spannungsmesskontakt 17 umgibt. Der technische Hintergrund und die Funktionsweise eines solchen Stromschattens ist beispielsweise in WO 2014/161624 A1 beschrieben. So ermöglicht der Stromschatten eine Verbesserung der Messgenauigkeit.

Figur 6 zeigt eine weitere Abwandlung des Strommesswiderstands 1 gemäß Figur 5, so dass zur Vermeidung von Wiederholungen wieder auf die vorstehende Beschreibung verwiesen wird, wobei für entsprechende Einzelheiten dieselben Bezugszeichen verwendet werden.

Eine Besonderheit dieses Ausführungsbeispiels besteht darin, dass in dem anderen Stromanschlussteil 3 ebenfalls ein Einschnitt 28 angeordnet ist.

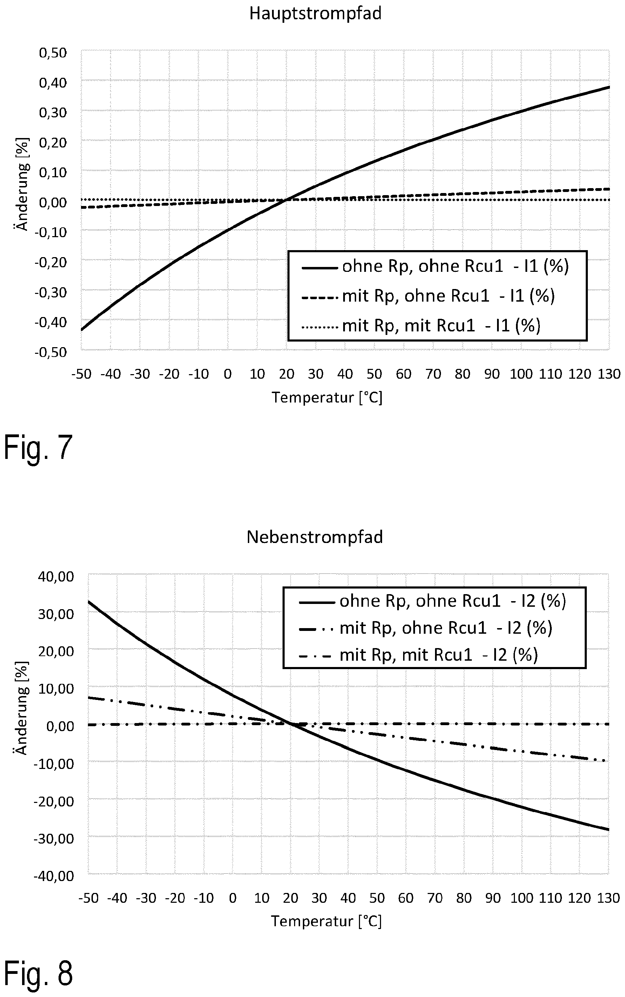

Figur 7 zeigt die Temperaturabhängigkeit der Strommessung des Hauptstroms I1 in verschiedenen Varianten. Die durchgezogene Linie zeigt hierbei den Verlauf der Änderung ohne den Ausgleichswiderstand R_{P} bzw. 13 und ohne die Berücksichtigung des ohmschen Widerstands R_{CU1} der Stromanschlussteile 2, 3. Die gestrichelte Linie zeigt dagegen den Verlauf unter Berücksichtigung des Ausgleichswiderstands 13. Schließlich zeigt die gepunktete Linie den Verlauf unter Berücksichtigung des Ausgleichswiderstands R_{P} und auch unter Berücksichtigung des ohmschen Widerstands R_{CU1} der Stromanschlussteile 2,3.

Figur 8 zeigt die Temperaturabhängigkeit der Strommessung des Nebenstrom I2 zwei in dem Nebenstrompfad 26 für die gleichen Varianten wie in Figur 7.

### Bezugszeichenliste

- 1: Niederohmiger Strommesswiderstand
- 2: Stromanschlussteil des Strommesswiderstands zum Einleiten des zu messenden Stroms
- 3: Stromanschlussteil des Strommesswiderstands zum Abführen des zu messenden Stroms
- 4: Widerstandselement des Strommesswiderstands
- 5, 6: Bohrungen in dem Strommesswiderstand zum Befestigen von Stromkontakten
- 7: Leiterplatte
- 8: Durchkontaktierung in der Leiterplatte vor dem Ausgleichswiderstand
- 9: Durchkontaktierung in der Leiterplatte hinter dem Ausgleichswiderstand
- 10: Leiterbahn auf der Leiterplatte vor dem Ausgleichswiderstand
- 11: Leiterbahn auf der Leiterplatte zwischen dem Ausgleichswiderstand und dem Magnetfeldsensor
- 12: Leiterbahn auf der Leiterplatte hinter dem Magnetfeldsensor
- 13: Ausgleichswiderstand
- 14: Hall-Sensor
- 15-20: Spannungsmesskontakte zur Spannungsmessung über dem Widerstandselement des Strommesswiderstands
- 21-24: Einschnitte in den Stromanschlussteilen
- 25: Hauptstrompfad
- 26: Nebenstrompfad
- 27, 28: Einschnitte (Stromschatten)
- I: Strom, der zu messen ist
- I1: Hauptstrom
- I2: Nebenstrom
- R_{Shunt}: Widerstand des Widerstandselements des Strommesswiderstands
- R_{Cu1}: Widerstand der Stromanschlussteile des Strommesswiderstands
- R_{P}: Widerstand des Widerstandselements des Ausgleichswiderstands
- R_{CU2}: Widerstand der Stromanschlussteile des Ausgleichswiderstands
- R_{Cu0}: Widerstand der Nebenstrompfads vor und hinter dem Ausgleichswiderstand
- U_{Hall}: Hall-Spannung
- U2/U3: Spannungsmesskontakte zur Spannungsmessung über dem Widerstandselement des Strommesswiderstands
- U2a/U3a: Spannungsmesskontakte zur Spannungsmessung über dem Widerstandselement des Strommesswiderstands
- U5/U6: Spannungsmesskontakte zur Spannungsmessung über dem Widerstandselement des Ausgleichswiderstands

## Patentansprüche

1. Strommessvorrichtung zur Messung eines elektrischen Stroms (I), mit
a) einem niederohmigen Strommesswiderstand (1) zur Strommessung gemäß der Vierleitertechnik, und
b) einem Magnetfeldsensor (14), insbesondere als Hall-Sensor oder als magnetoresistiver Magnetfeldsensor, zur redundanten Strommessung,
c) wobei der zu messende elektrische Strom (I) in der Strommessvorrichtung aufgeteilt wird in einen Hauptstrompfad (25) mit einem Hauptstrom (I1) und einen Nebenstrompfad (26) mit einem Nebenstrom (I2), wobei der Hauptstrompfad (25) und der Nebenstrompfad (26) zusammen eine Parallelschaltung bilden,
d) wobei der niederohmige Strommesswiderstand (1) in dem Hauptstrompfad (25) angeordnet ist und von dem Hauptstrom (I1) durchflossen wird, und
e) wobei der Magnetfeldsensor (14) in dem Nebenstrompfad (26) angeordnet ist und den Nebenstrom (I2) misst,
**dadurch gekennzeichnet,**
f) **dass** die Parallelschaltung so ausgelegt ist, dass der Hauptstrom (I1) durch den Hauptstrompfad (25) mit dem niederohmigen Strommesswiderstand (1) größer ist als der Nebenstrom (I2) in dem Nebenstrompfad (26) mit dem Magnetfeldsensor (14), nämlich um einen Faktor von mindestens 10.

2. Strommessvorrichtung nach Anspruch 1, **dadurch gekennzeichnet, dass** die Parallelschaltung so ausgelegt ist, dass der Hauptstrom (I1) durch den Hauptstrompfad (25) mit dem niederohmigen Strommesswiderstand (1) größer ist als der Nebenstrom (I2) in dem Nebenstrompfad (26) mit dem Magnetfeldsensor (14), nämlich um einen Faktor von mindestens 100, 200, 500 oder 1000.

3. Strommessvorrichtung nach einem der vorhergehenden Ansprüche,
**dadurch gekennzeichnet,**
a) **dass** der Nebenstrompfad (26) einen elektrischen Widerstandswert aufweist, der um einen Faktor von mindestens 10, 100, 200, 500 oder 1000 größer ist als der Widerstand des Hauptstrompfads (25), und/oder
b) **dass** der Widerstandswert des Hauptstrompfads (25) im Bereich von 1 µΩ, 10 µΩ, 20 µΩ, 50 µΩ, 100 µΩ, 200 µΩ oder 500 µΩ liegt mit einer Abweichung von maximal ±50%, ±20%, ±10%, ±5%, ±2% oder ±1%, und/oder
c) **dass** der Widerstandswert des Nebenstrompfads im Bereich von 1 mΩ, 2 mΩ, 5 mΩ, 10 mΩ, 20 mΩ, 50 mΩ oder 100 mΩ liegt mit einer Abweichung von maximal ±50%, ±20%, ±10%, ±5%, ±2% oder ±1%.

4. Strommessvorrichtung nach einem der vorhergehenden Ansprüche, **dadurch gekennzeichnet, dass** der niederohmige Strommesswiderstand (1) einen größeren Strommessbereich aufweist als der Magnetfeldsensor (14), insbesondere um einen Faktor von mindestens 10, 100, 200, 500 oder 1000.

5. Strommessvorrichtung nach einem der vorhergehenden Ansprüche,
**dadurch gekennzeichnet,**
a) **dass** in dem Nebenstrompfad (26) mit dem Magnetfeldsensor (14) ein Ausgleichswiderstand (13) angeordnet ist,
b) **dass** der Ausgleichswiderstand (13) hinsichtlich seines Widerstandswerts so bemessen ist, dass die Temperaturabhängigkeit des Widerstandswerts des Leitermaterials mindestens teilweise kompensiert wird,
c) **dass** der Hauptstrompfad (25) und der Nebenstrompfad (26) jeweils Leitermaterial mit einem bestimmten ersten Temperaturkoeffizienten bezüglich des Widerstandswerts und Widerstandsmaterial mit einem bestimmten zweiten Temperaturkoeffizienten bezüglich des Widerstandswerts enthält,
d) **dass** der erste Temperaturkoeffizient des Leitermaterials vorzugsweise wesentlich größer ist als der zweite Temperaturkoeffizient des Widerstandsmaterials, insbesondere um einen Faktor von mindestens 10, 20, 50, 100 oder 200,
e) **dass** der Ausgleichswiderstand (13) in dem Nebenstrompfad (26) aus einem Widerstandsmaterial besteht, das vorzugsweise einen wesentlich geringeren Temperaturkoeffizienten aufweist als das Leitermaterial.

6. Strommessvorrichtung nach Anspruch 5, **dadurch gekennzeichnet, dass** der Hauptstrompfad (25) und der Nebenstrompfad (26) das gleiche Widerstandsverhältnis aufweisen zwischen dem Widerstandswert des Leitermaterials und dem Widerstandswert des Widerstandsmaterials, insbesondere mit einer Abweichung von weniger als ±20%, ±10%, ±5%, ±2%.

7. Strommessvorrichtung nach Anspruch 5 oder 6,
**dadurch gekennzeichnet,**
a) **dass** der erste Temperaturkoeffizient des Leitermaterials im Bereich von 1.000-10.000 oder 3.600-4.000 ppm/K liegt, und/oder
b) **dass** der zweite Temperaturkoeffizient des Widerstandsmaterials im Bereich von 0 bis ±100 ppm/K, 0 bis ±50 ppm/K, 0 bis ±20 ppm/K oder 0 bis ±10 ppm/K liegt.

8. Strommessvorrichtung nach einem der vorhergehenden Ansprüche, **dadurch gekennzeichnet, dass** der niederohmige Strommesswiderstand (1) plattenförmig ist, mit plattenförmigen Stromanschlussteilen (2, 3) und einem plattenförmigen Widerstandselement (4), wobei das plattenförmige Widerstandselement (4) in Stromflussrichtung zwischen den beiden plattenförmigen Stromanschlussteilen (2, 3) angeordnet ist.

9. Strommessvorrichtung nach Anspruch 8, **dadurch gekennzeichnet,**
a) **dass** mindestens eines der beiden plattenförmigen Stromanschlussteile (2, 3) des niederohmigen Strommesswiderstands (1) seitlich einseitig oder beidseitig einen Einschnitt (21-24) zur Temperaturkompensation aufweist, und/oder
b) **dass** mindestens eines der beiden plattenförmigen Stromanschlussteile (2, 3) mittig einen Einschnitt (27, 28) zum Trimmen des Widerstandswerts aufweist.

10. Strommessvorrichtung nach einem der Ansprüche 8 bis 9,
**dadurch gekennzeichnet,**
a) **dass** an den plattenförmigen Stromanschlussteilen (2, 3) des niederohmigen Strommesswiderstands (1) mehrere Spannungsmesskontakte (15-20; U2, U2a, U3, U3a) angeordnet sind,
b) **dass** die Spannungsmesskontakte (15-20; U2, U2a, U3, U3a) quer zur Stromflussrichtung verteilt sind, und/oder
c) **dass** der mittige Einschnitt (27) in dem plattenförmigen Stromanschlussteil (2) einen der Spannungsmesskontakte (15-20; U2, U2a, U3, U3a) als Stromschatten umgibt.

11. Strommessvorrichtung nach einem der Ansprüche 8 bis 10,
**dadurch gekennzeichnet,**
a) **dass** auf dem plattenförmigen Strommesswiderstand (1) eine Leiterplatte (7) angeordnet ist, und/oder
b) **dass** die Leiterplatte (7) mittels jeweils mindestens einer Durchkontaktierung (8, 9) die beiden Stromanschlussteile (2, 3) des niederohmigen Strommesswiderstands (1) kontaktiert, und/oder
c) **dass** der Magnetfeldsensor (14) auf der Leiterplatte (7) angeordnet ist, und/oder
d) **dass** der Magnetfeldsensor (14) einerseits und der Strommesswiderstand (1) andererseits auf gegenüberliegenden Seiten der Leiterplatte (7) angeordnet sind, und/oder
e) **dass** der Ausgleichswiderstand (13) auf der Leiterplatte (7) angeordnet ist, insbesondere auf derselben Seite wie der Magnetfeldsensor (14), und/oder
f) **dass** der Nebenstrompfad (26) auf und/oder in der Leiterplatte (7) verläuft, während der Hauptstrompfad (25) durch den niederohmigen Strommesswiderstand (1) verläuft, und/oder
g) **dass** auf der Leiterplatte (7) eine Auswertungsschaltung angeordnet ist, die folgendes erfasst:
g1) den Spannungsabfall über dem Widerstandselement (4) des niederohmigen Strommesswiderstands (1),
g2) das Ausgangssignal des Magnetfeldsensors (14), und/oder
g3) den Spannungsabfall über dem Ausgleichswiderstand (13) in dem Nebenstrompfad (26),
und/oder
h) **dass** die Auswertungsschaltung eine Schnittstelle aufweist, um das Ausgangssignal des Magnetfeldsensors (14) auszugeben.

12. Strommessvorrichtung nach Anspruch 11, **dadurch gekennzeichnet,**
a) **dass** die Leiterplatte (7) mehrere Lagen aufweist,
b) **dass** der Ausgleichswiderstand (13) auf der obersten Lage der Leiterplatte (7) angeordnet ist,
c) **dass** der Nebenstrompfad (26) stromaufwärts vor dem Ausgleichswiderstand (13) auf mehrere Lagen der Leiterplatte (7) aufgeteilt ist,
d) **dass** der Nebenstrompfad (26) stromaufwärts vor dem Ausgleichswiderstand (13) auf der obersten Lage der Leiterplatte (7) zusammengeführt ist und dann vollständig durch den Ausgleichswiderstand (13) auf der obersten Lage der Leiterplatte (7) verläuft, und
e) **dass** der Nebenstrompfad (26) stromabwärts hinter dem Ausgleichswiderstand (13) wieder auf mehrere Lagen der Leiterplatte (7) aufgeteilt ist.

13. Strommessvorrichtung nach einem der vorhergehenden Ansprüche, **gekennzeichnet durch** Spannungsmesskontakte (U5, U6) zur Messung der über dem Ausgleichswiderstand (13) abfallenden elektrischen Spannung für eine Strommessung gemäß der Vierleitertechnik auch in dem Nebenstrompfad (26), so dass die Strommessung in dem Nebenstrompfad (26) sowohl gemäß der Vierleitertechnik als auch **durch** den Magnetfeldsensor (14) erfolgt.

14. Strommessvorrichtung nach einem der vorhergehenden Ansprüche,
**dadurch gekennzeichnet,**
a) **dass** die Strommessvorrichtung einen Hochspannungsbereich und einen Niederspannungsbereich aufweist,
b) **dass** der Magnetfeldsensor (14) den Nebenstrom (I2) eingangsseitig in dem Hochspannungsbereich misst, und
c) **dass** der Magnetfeldsensor (14) das Ausgangssignal ausgangsseitig in dem Niederspannungsbereich ausgibt,
d) **dass** der Ausgleichswiderstand (13) vorzugsweise in dem Hochspannungsbereich angeordnet ist,
e) **dass** der Magnetfeldsensor (14) vorzugsweise eine Isolation enthält, die den Niederspannungsbereich von dem Hochspannungsbereich isoliert.

15. Strommessvorrichtung nach einem der vorhergehenden Ansprüche,
**dadurch gekennzeichnet,**
a) **dass** die Strommessvorrichtung einen Strommessbereich aufweist, der bis mindestens 0,5 kA, 1 kA, 2 kA, 5 kA, 10 kA oder 20 kA reicht, und/oder
b) **dass** die Strommessvorrichtung eingangsseitig eine Betriebsspannung von mindestens 100 V, 500 V oder 1 kV erlaubt, und/oder
c) **dass** das Leitermaterial der Stromanschlussteile (2, 3) des niederohmigen Strommesswiderstands (1) Kupfer oder eine Kupferlegierung oder Aluminium oder eine Aluminiumlegierung ist, und/oder
d) **dass** das Widerstandsmaterial des Widerstandselements (4) des niederohmigen Strommesswiderstands (1) eine der folgenden Legierungen ist:
d1) eine Kupferlegierung, insbesondere eine Kupfer-Mangan-Nickel-Legierung, insbesondere CuMn12Ni2, Cu84Ni4Mn12 oder Cu65Mn25Ni10, oder eine Kupfer-Mangan-Zinn-Legierung, insbesondere CuMn7Sn2,3, oder eine Kupfer-Chrom-Legierung,
d2) eine Nickellegierung, insbesondere NiCr oder CuNi, und/oder
e) **dass** das Leitermaterial der Stromanschlussteile (2, 3) des niederohmigen Strommesswiderstands (1) einen geringeren spezifischen elektrischen Widerstand hat als das Widerstandsmaterial des Widerstandselements (4) des niederohmigen Strommesswiderstands (1), und/oder
f) **dass** das Widerstandsmaterial des Widerstandselements (4) des niederohmigen Strommesswiderstands (1) einen spezifischen elektrischen Widerstand von weniger als 1000 µΩcm, 500 µΩcm, 250 µΩcm, 100 µΩcm oder 50 µΩcm aufweist, und/oder
g) **dass** das Leitermaterial der Stromanschlussteile (2, 3) des niederohmigen Strommesswiderstands (1) einen spezifischen elektrischen Widerstand von weniger als 20 µΩcm, 10 µΩcm, 5 µΩcm oder 2 µΩcm aufweist, und/oder
h) **dass** der magnetoresistive Magnetfeldsensor (14) ein GMR-Sensor ist, und/oder
i) **dass** der niederohmige Strommesswiderstand (1) einen Widerstandswert hat, der höchstens 500 mΩ, 200 mΩ, 100 mΩ, 50 mΩ, 20 mΩ, 10 mΩ, 5 mΩ, 2 mΩ oder 1 mΩ beträgt.

## Claims

1. Current measuring apparatus for measuring an electric current (I), comprising
a) a low-resistance current measuring resistor (1) for current measurement according to the four-wire technique, and
b) a magnetic field sensor (14), in particular as a Hall sensor or as a magnetoresistive magnetic field sensor, for redundant current measurement,
c) wherein the electric current (I) to be measured is divided in the current measuring apparatus into a main current path (25) with a main current (I1) and a secondary current path (26) with a secondary current (I2), the main current path (25) and the secondary current path (26) together forming a parallel circuit,
d) wherein the low-resistance current measuring resistor (1) is arranged in the main current path (25) and has the main current (I1) flowing through it, and
e) wherein the magnetic field sensor (14) is arranged in the secondary current path (26) and measures the secondary current (I2),
**characterized in that**
f) the parallel circuit is designed such that the main current (I1) through the main current path (25) with the low-resistance current measuring resistor (1) is greater than the secondary current (I2) in the secondary current path (26) with the magnetic field sensor (14), namely by a factor of at least 10.

2. Current measuring apparatus according to claim 1, **characterized in that** the parallel circuit is designed such that the main current (I1) through the main current path (25) with the low-resistance current measuring resistor (1) is greater than the secondary current (I2) in the secondary current path (26) with the magnetic field sensor (14), namely by a factor of at least 100, 200, 500 or 1000.

3. Current measuring apparatus according to one of the preceding claims,
**characterized in**
a) **that** the secondary current path (26) has an electrical resistance value which is greater than the resistance of the main current path (25) by a factor of at least 10, 100, 200, 500 or 1000, and/or
b) **that** the resistance value of the main current path (25) lies in the range of 1 µΩ, 10 µΩ, 20 µΩ, 50 µΩ, 100 µΩ, 200 µΩ or 500 µΩ with a deviation of at most ±50%, ±20%, ±10%, ±5%, ±2% or ±1%, and/or
c) **that** the resistance value of the secondary current path lies in the range of 1 mΩ, 2 mΩ, 5 mΩ, 10 mΩ, 20 mΩ, 50 mΩ or 100 mΩ with a deviation of maximum ±50%, ±20%, ±10%, ±5%, ±2% or ±1%.

4. Current measuring apparatus according to one of the preceding claims, **characterized in that** the low-resistance current measuring resistor (1) has a larger current measuring range than the magnetic field sensor (14), in particular by a factor of at least 10, 100, 200, 500 or 1000.

5. Current measuring apparatus according to any one of the preceding claims,
**characterized in**
a) **that** a compensating resistor (13) is arranged in the secondary current path (26) with the magnetic field sensor (14),
b) **that** the compensating resistor (13) is dimensioned with respect to its resistance value such that the temperature dependence of the resistance value of the conductor material is at least partially compensated for,
c) **that** the main current path (25) and the secondary current path (26) each contain conductor material with a specific first temperature coefficient with respect to the resistance value and resistor material with a specific second temperature coefficient with respect to the resistance value,
d) **that** the first temperature coefficient of the conductor material is preferably substantially greater than the second temperature coefficient of the resistor material, in particular by a factor of at least 10, 20, 50, 100 or 200,
e) **that** the compensating resistor (13) in the secondary current path (26) consists of a resistor material which preferably has a substantially lower temperature coefficient than the conductor material.

6. Current measuring apparatus according to claim 5, **characterized in that** the main current path (25) and the secondary current path (26) have the same resistance ratio between the resistance value of the conductor material and the resistance value of the resistor material, in particular with a deviation of less than ±20%, ±10%, ±5%, ±2%.

7. Current measuring apparatus according to claim 5 or 6,
**characterized in**
a) **that** the first temperature coefficient of the conductor material is in the range of 1,000-10,000 or 3,600-4,000 ppm/K, and/or
b) **that** the second temperature coefficient of the resistor material is in the range of 0 to ±100 ppm/K, 0 to ±50 ppm/K, 0 to ±20 ppm/K or 0 to ±10 ppm/K.

8. Current measuring apparatus according to one of the preceding claims, **characterized in that** the low-resistance current measuring resistor (1) is plate-shaped, with plate-shaped current connecting parts (2, 3) and a plate-shaped resistor element (4), the plate-shaped resistor element (4) being arranged between the two plate-shaped current connecting parts (2, 3) in the direction of current flow.

9. Current measuring apparatus according to claim 8, **characterized in,**
a) **that** at least one of the two plate-shaped current connecting parts (2, 3) of the low-resistance current measuring resistor (1) has an incision (21-24) on one or both sides for temperature compensation, and/or
b) **that** at least one of the two plate-shaped current connecting parts (2, 3) has an incision (27, 28) in the center for trimming the resistance value.

10. Current measuring apparatus according to any one of claims 8 to 9,
**characterized in**
a) **that** a plurality of voltage measuring contacts (15-20; U2, U2a, U3, U3a) are arranged on the plate-shaped current connecting parts (2, 3) of the low-resistance current measuring resistor (1),
b) **that** the voltage measuring contacts (15-20; U2, U2a, U3, U3a) are distributed transversely to the current flow direction, and/or
c) **that** the central incision (27) in the plate-shaped current connecting part (2) surrounds one of the voltage measuring contacts (15-20; U2, U2a, U3, U3a) as a current shadow.

11. Current measuring apparatus according to one of claims 8 to 10,
**characterized in**
a) **that** a printed circuit board (7) is arranged on the plate-shaped current measuring resistor (1), and/or
b) **that** the printed circuit board (7) makes contact with the two current connecting parts (2, 3) of the low-resistance current measuring resistor (1) by means of in each case at least one through-plating (8, 9), and/or
c) **that** the magnetic field sensor (14) is arranged on the printed circuit board (7), and/or
d) **that** the magnetic field sensor (14) on the one hand and the current measuring resistor (1) on the other hand are arranged on opposite sides of the printed circuit board (7), and/or
e) **that** the compensating resistor (13) is arranged on the printed circuit board (7), in particular on the same side as the magnetic field sensor (14), and/or
f) **that** the secondary current path (26) runs on and/or in the printed circuit board (7), while the main current path (25) runs through the low-resistance current measuring resistor (1), and/or
g) **that** an evaluation circuit is arranged on the printed circuit board (7), which detects the following:
g1) the voltage drop across the resistance element (4) of the low-resistance current measuring resistor (1),
g2) the output signal of the magnetic field sensor (14), and/or
g3) the voltage drop across the compensating resistor (13) in the secondary current path (26),
and/or
h) **that** the evaluation circuit has an interface for outputting the output signal of the magnetic field sensor (14).

12. Current measuring apparatus according to claim 11, **characterized in,**
a) **that** the printed circuit board (7) has several layers,
b) **that** the compensating resistor (13) is arranged on the uppermost layer of the printed circuit board (7),
c) **that** the secondary current path (26) upstream of the compensating resistor (13) is divided among a plurality of layers of the printed circuit board (7),
d) **that** the secondary current path (26) is brought together upstream of the compensating resistor (13) on the uppermost layer of the printed circuit board (7) and then runs completely through the compensating resistor (13) on the uppermost layer of the printed circuit board (7), and
e) **that** the secondary current path (26) downstream of the compensating resistor (13) is again divided into several layers of the printed circuit board (7).

13. Current measuring apparatus according to one of the preceding claims, **characterized by** voltage measuring contacts (U5, U6) for measuring the electrical voltage dropping across the compensating resistor (13) for a current measurement according to the four-wire technique also in the secondary current path (26), so that the current measurement in the secondary current path (26) is carried out both according to the four-wire technique and by the magnetic field sensor (14).

14. Current measuring apparatus according to any of the preceding claims,
**characterized in**
a) **that** the current measuring apparatus has a high-voltage area and a low-voltage area,
b) **that** the magnetic field sensor (14) measures the secondary current (I2) on the input side in the high-voltage area, and
c) **that** the magnetic field sensor (14) outputs the output signal on the output side in the low-voltage area,
d) **that** the compensating resistor (13) is preferably arranged in the high-voltage area,
e) **that** the magnetic field sensor (14) preferably contains an insulation which insulates the low-voltage area from the high-voltage area.

15. Current measuring apparatus according to any of the preceding claims,
**characterized in**
a) **that** the current measuring apparatus has a current measuring range that extends to at least 0.5 kA, 1 kA, 2 kA, 5 kA, 10 kA or 20 kA, and/or
b) **that** the current measuring apparatus permits an operating voltage of at least 100 V, 500 V or 1 kV on the input side, and/or
c) **that** the conductor material of the current connecting parts (2, 3) of the low-resistance current measuring resistor (1) is copper or a copper alloy or aluminum or an aluminum alloy, and/or
d) **that** the resistance material of the resistance element (4) of the low-resistance current measuring resistor (1) is one of the following alloys:
d1) a copper alloy, in particular a copper-manganese-nickel alloy, in particular CuMn12Ni2, Cu84Ni4Mn12 or Cu65Mn25Ni10, or a copper-manganese-tin alloy, in particular CuMn7Sn2,3, or a copper-chromium alloy,
d2) a nickel alloy, in particular NiCr or CuNi, and/or
e) **that** the conductor material of the current connecting parts (2, 3) of the low-resistance current measuring resistor (1) has a lower specific electrical resistance than the resistance material of the resistance element (4) of the low-resistance current measuring resistor (1), and/or
f) **that** the resistive material of the resistor element (4) of the low-resistance current measuring resistor (1) has a specific electrical resistance of less than 1000 µΩcm, 500 µΩcm, 250 µΩcm, 100 µΩcm or 50 µΩcm, and/or
g) **that** the conductor material of the current connecting parts (2, 3) of the low-resistance current measuring resistor (1) has a specific electrical resistance of less than 20 µΩcm, 10 µΩcm, 5 µΩcm or 2 µΩcm, and/or
h) **that** the magnetoresistive magnetic field sensor (14) is a GMR sensor, and/or
i) **that** the low-resistance current measuring resistor (1) has a resistance value which is at most 500 mΩ, 200 mΩ, 100 mΩ, 50 mΩ, 20 mΩ, 10 mΩ, 5 mΩ, 2 mΩ or 1 mΩ.

## Revendications

1. Dispositif de mesure de courant pour la mesure d'un courant électrique (I), avec
a) une résistance de mesure de courant à faible impédance (1) pour la mesure de courant selon la technique à quatre fils, et
b) un capteur de champ magnétique (14), en particulier en tant que capteur Hall ou en tant que capteur de champ magnétique magnétorésistif, pour la mesure de courant redondante,
c) dans lequel le courant électrique (I) à mesurer dans le dispositif de mesure de courant est divisé en un chemin de courant principal (25) avec un courant principal (I1) et un chemin de courant secondaire (26) avec un courant secondaire (12), dans lequel le chemin de courant principal (25) et le chemin de courant secondaire (26) forment ensemble un montage en parallèle,
d) dans lequel la résistance de mesure de courant à faible impédance (1) est disposée dans le chemin de courant principal (25) et est traversée par le courant principal (I1), et
e) dans lequel le capteur de champ magnétique (14) est disposé dans le chemin de courant secondaire (26) et mesure le courant secondaire (12),
**caractérisé en ce**
f) **que** le montage en parallèle est conçu de sorte que le courant principal (I1) à travers le chemin de courant principal (25) avec la résistance de mesure de courant à faible impédance (1) est supérieur au courant secondaire (12) dans le chemin de courant secondaire (26) avec le capteur de champ magnétique (14), à savoir d'un facteur d'au moins 10.

2. Dispositif de mesure de courant selon la revendication 1, **caractérisé en ce que** le montage en parallèle est conçu de sorte que le courant principal (I1) à travers le chemin de courant principal (25) avec la résistance de mesure de courant à faible impédance (1) est supérieur au courant secondaire (12) dans le chemin de courant secondaire (26) avec le capteur de champ magnétique (14), à savoir d'un facteur d'au moins 100, 200, 500 ou 1 000.

3. Dispositif de mesure de courant selon l'une quelconque des revendications précédentes,
**caractérisé en ce**
a) **que** le chemin de courant secondaire (26) présente une valeur de résistance électrique qui est supérieure d'un facteur d'au moins 10, 100, 200, 500 ou 1 000 à la résistance du chemin de courant principal (25), et/ou
b) **que** la valeur de résistance du chemin de courant principal (25) se situe dans la plage de 1 µΩ, 10 µΩ, 20 µΩ, 50 µΩ, 100 µΩ, 200 µΩ ou 500 µΩ avec un écart maximal de ±50 %, ±20 %, ±10 %, ±5 %, ±2 % ou ±1 %, et/ou
c) **que** la valeur de résistance du chemin de courant secondaire se situe dans la plage de 1 mΩ, 2 mΩ, 5 mΩ, 10 mΩ, 20 mΩ, 50 mΩ ou 100 mΩ avec un écart maximal de ±50 %, ±20 %, ±10 %, ±5 %, ±2 % ou ±1 %.

4. Dispositif de mesure de courant selon l'une quelconque des revendications précédentes, **caractérisé en ce que** la résistance de mesure de courant à faible impédance (1) présente une plage de mesure de courant plus grande que le capteur de champ magnétique (14), en particulier d'un facteur d'au moins 10, 100, 200, 500 ou 1 000.

5. Dispositif de mesure de courant selon l'une quelconque des revendications précédentes,
**caractérisé en ce**
a) **qu'**une résistance de compensation (13) est disposée dans le chemin de courant secondaire (26) avec le capteur de champ magnétique (14),
b) **que** la résistance de compensation (13) est dimensionnée en ce qui concerne sa valeur de résistance de sorte que la dépendance de température de la valeur de résistance du matériau conducteur est au moins partiellement compensée,
c) **que** le chemin de courant principal (25) et le chemin de courant secondaire (26) contiennent chacun un matériau conducteur avec un premier coefficient de température déterminé par rapport à la valeur de résistance et un matériau résistif avec un deuxième coefficient de température déterminé par rapport à la valeur de résistance,
d) **que** le premier coefficient de température du matériau conducteur est de préférence sensiblement supérieur au deuxième coefficient de température du matériau résistif, en particulier d'un facteur d'au moins 10, 20, 50, 100 ou 200,
e) **que** la résistance de compensation (13) dans le chemin de courant secondaire (26) est constituée d'un matériau résistif qui présente de préférence un coefficient de température sensiblement plus petit que le matériau conducteur.

6. Dispositif de mesure de courant selon la revendication 5, **caractérisé en ce que** le chemin de courant principal (25) et le chemin de courant secondaire (26) présentent le même rapport de résistance entre la valeur de résistance du matériau conducteur et la valeur de résistance du matériau résistif, en particulier avec un écart inférieur à ±20 %, ±10 %, ±5 %, ±2 %.

7. Dispositif de mesure de courant selon la revendication 5 ou 6,
**caractérisé en ce**
a) **que** le premier coefficient de température du matériau conducteur se situe dans la plage de 1 000-10 000 ou 3 600-4 000 ppm/K, et/ou
b) **que** le deuxième coefficient de température du matériau résistif se situe dans la plage de 0 à ±100 ppm/K, 0 à ±50 ppm/K, 0 à ±20 ppm/K ou 0 à ±10 ppm/K.

8. Dispositif de mesure de courant selon l'une quelconque des revendications précédentes, **caractérisé en ce que** la résistance de mesure de courant à faible impédance (1) est en forme de plaque, avec des pièces de raccordement électrique en forme de plaque (2, 3) et un élément résistif en forme de plaque (4), dans lequel l'élément résistif en forme de plaque (4) est disposé dans le sens du flux de courant entre les deux pièces de raccordement électrique en forme de plaque (2, 3).

9. Dispositif de mesure de courant selon la revendication 8, **caractérisé en ce**
a) **qu'**au moins l'une des deux pièces de raccordement électrique en forme de plaque (2, 3) de la résistance de mesure de courant à faible impédance (1) présente une encoche (21-24) latéralement d'un côté ou des deux côtés pour la compensation de température, et/ou
b) **qu'**au moins l'une des deux pièces de raccordement électrique en forme de plaque (2, 3) présente au centre une encoche (27, 28) pour l'équilibrage de la valeur de résistance.

10. Dispositif de mesure de courant selon l'une quelconque des revendications 8 à 9,
**caractérisé en ce**
a) **que** plusieurs contacts de mesure de tension (15-20 ; U2, U2a, U3, U3a) sont disposés sur les pièces de raccordement électrique en forme de plaque (2, 3) de la résistance de mesure de courant à faible impédance (1),
b) **que** les contacts de mesure de tension (15-20 ; U2, U2a, U3, U3a) sont répartis transversalement par rapport au sens du flux de courant, et/ou
c) **que** l'encoche (27) centrale dans la pièce de raccordement électrique en forme de plaque (2) entoure l'un des contacts de mesure de tension (15-20 ; U2, U2a, U3, U3a) comme ombre de courant.

11. Dispositif de mesure de courant selon l'une quelconque des revendications 8 à 10,
**caractérisé en ce**
a) **qu'**une carte de circuit imprimé (7) est disposée sur la résistance de mesure de courant en forme de plaque (1), et/ou
b) **que** la carte de circuit imprimé (7) contacte les deux pièces de raccordement électrique (2, 3) de la résistance de mesure de courant à faible impédance (1) au moyen de respectivement au moins un trou d'interconnexion (8, 9), et/ou
c) **que** le capteur de champ magnétique (14) est disposé sur la carte de circuit imprimé (7), et/ou
d) **que** le capteur de champ magnétique (14) d'une part et la résistance de mesure de courant (1) d'autre part sont disposés sur des côtés opposés de la carte de circuit imprimé (7), et/ou
e) **que** la résistance de compensation (13) est disposée sur la carte de circuit imprimé (7), en particulier du même côté que le capteur de champ magnétique (14), et/ou
f) **que** le chemin de courant secondaire (26) passe sur et/ou dans la carte de circuit imprimé (7), tandis que le chemin de courant principal (25) passe à travers la résistance de mesure de courant à faible impédance (1), et/ou
g) **qu'**un circuit d'évaluation est disposé sur la carte de circuit imprimé (7), qui détecte ce qui suit :
g1) la chute de tension sur l'élément résistif (4) de la résistance de mesure de courant à faible impédance (1),
g2) le signal de sortie du capteur de champ magnétique (14), et/ou
g3) la chute de tension au-dessus de la résistance de compensation (13) dans le chemin de courant secondaire (26), et/ou
h) **que** le circuit d'évaluation présente une interface pour émettre le signal de sortie du capteur de champ magnétique (14) .

12. Dispositif de mesure de courant selon la revendication 11, **caractérisé en ce**
a) **que** la carte de circuit imprimé (7) présente plusieurs couches,
b) **que** la résistance de compensation (13) est disposée sur la couche la plus haute de la carte de circuit imprimé (7),
c) **que** le chemin de courant secondaire (26) est divisé en amont de la résistance de compensation (13) en plusieurs couches de la carte de circuit imprimé (7),
d) **que** le chemin de courant secondaire (26) est fusionné en amont de la résistance de compensation (13) sur la couche la plus haute de la carte de circuit imprimé (7) et passe ensuite entièrement à travers la résistance de compensation (13) sur la couche la plus haute de la carte de circuit imprimé (7), et
e) **que** le chemin de courant secondaire (26) est à nouveau divisé en plusieurs couches de la carte de circuit imprimé (7) en aval de la résistance de compensation (13).

13. Dispositif de mesure de courant selon l'une quelconque des revendications précédentes, **caractérisé par** des contacts de mesure de tension (U5, U6) pour la mesure de la tension électrique chutant au-dessus de la résistance de compensation (13) pour une mesure de courant selon la technique à quatre fils également dans le chemin de courant secondaire (26), de sorte que la mesure de courant dans le chemin de courant secondaire (26) s'effectue aussi bien selon la technique à quatre fils que par le capteur de champ magnétique (14) .

14. Dispositif de mesure de courant selon l'une quelconque des revendications précédentes,
**caractérisé en ce**
a) **que** le dispositif de mesure de courant présente une plage haute tension et une plage basse tension,
b) **que** le capteur de champ magnétique (14) mesure le courant secondaire (12) côté entrée dans la plage haute tension, et
c) **que** le capteur de champ magnétique (14) émet le signal de sortie côté sortie dans la plage basse tension,
d) **que** la résistance de compensation (13) est disposée de préférence dans la plage haute tension,
e) **que** le capteur de champ magnétique (14) comporte de préférence une isolation qui isole la plage basse tension de la plage haute tension.

15. Dispositif de mesure de courant selon l'une quelconque des revendications précédentes,
**caractérisé en ce**
a) **que** le dispositif de mesure de courant présente une plage de mesure de courant qui va jusqu'à au moins 0,5 kA, 1 kA, 2 kA, 5 kA, 10 kA ou 20 kA, et/ou
b) **que** le dispositif de mesure de courant permet une tension de service d'au moins 100 V, 500 V ou 1 kV côté entrée, et/ou
c) **que** le matériau conducteur des pièces de raccordement électrique (2, 3) de la résistance de mesure de courant à faible impédance (1) est du cuivre ou un alliage de cuivre ou de l'aluminium ou un alliage d'aluminium, et/ou
d) **que** le matériau résistif de l'élément résistif (4) de la résistance de mesure de courant à faible impédance (1) est un des alliages suivants :
d1) un alliage de cuivre, en particulier un alliage cuivre-manganèse-nickel, en particulier CuMn12Ni2, Cu84Ni4Mn12 ou Cu65Mn25Ni10, ou un alliage cuivre-manganèse-étain, en particulier CuMn7Sn2,3, ou un alliage cuivre-chrome,
d2) un alliage de nickel, en particulier NiCr ou CuNi, et/ou
e) **que** le matériau conducteur des pièces de raccordement électrique (2, 3) de la résistance de mesure de courant à faible impédance (1) présente une résistance électrique spécifique inférieure à celle du matériau résistif de l'élément résistif (4) de la résistance de mesure de courant à faible impédance (1), et/ou
f) **que** le matériau résistif de l'élément résistif (4) de la résistance de mesure de courant à faible impédance (1) présente une résistance électrique spécifique inférieure à 1000 pQcm, 500 pQcm, 250 pQcm, 100 pQcm ou 50 pQcm, et/ou
g) **que** le matériau conducteur des pièces de raccordement électrique (2, 3) de la résistance de mesure de courant à faible impédance (1) présente une résistance électrique spécifique inférieure à 20 pQcm, 10 pQcm, 5 pQcm ou 2 pQcm, et/ou
h) **que** le capteur de champ magnétique magnétorésistif (14) est un capteur MRG, et/ou
i) **que** la résistance de mesure de courant à faible impédance (1) a une valeur de résistance qui atteint au plus 500 mQ, 200 mQ, 100 mQ, 50 mQ, 20 mQ, 10 mQ, 5 mQ, 2 mΩ ou 1 mQ.
